**Europäisches Patentamt**

**European Patent Office**

**Office européen des brevets**

(19)

(11) **EP 1 550 953 A1**

(12) **EUROPEAN PATENT APPLICATION**

(43) Date of publication:
06.07.2005 Bulletin 2005/27

(51) Int Cl.⁷: **G06F 13/16**, G11C 7/10

(21) Application number: 03425829.3

(22) Date of filing: 29.12.2003

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | • **Siemens AG**<br>**80333 München (DE)**<br><br>(72) Inventors:<br>• **Antonelli, Massimo**<br>**67100 L'Aquila (IT)**<br>• **Capezzali, Roberto**<br>**67100 L'Aquila (IT)** |
| (71) Applicants:<br>• **CNX S.p.A.**<br>**20126 Milano (IT)** | |

(54) **Method and device implementing a time multiplexed access to a single dual port RAM from several data source with independent clocks**

(57)     The present invention relates to a method for sharing the access, both in writing and in reading mode, to a single dual-port memory among many data sources, supporting fully independent and concurrent access from both ports.

The method is implemented by means a device receiving N independent data stream at the input of N word framers and address generators. The word framer and address generators deserialize the data streams to a given word dimension and generate a correct writing address to the dual-port RAM. Each word framer and address generator outputs parallel data bus, address and enable signal to a RAM access multiplexer performing the time multiplexing of incoming data, addresses and enables to the writing interface of the dual-port RAM.

FIG. 2a

EP 1 550 953 A1

## Description

## Field of the invention

The present invention relates to a method for sharing the access, both in writing and in reading mode, to a single dual-port memory among many data sources, supporting fully independent and concurrent access from both ports without waits states.

## Background art

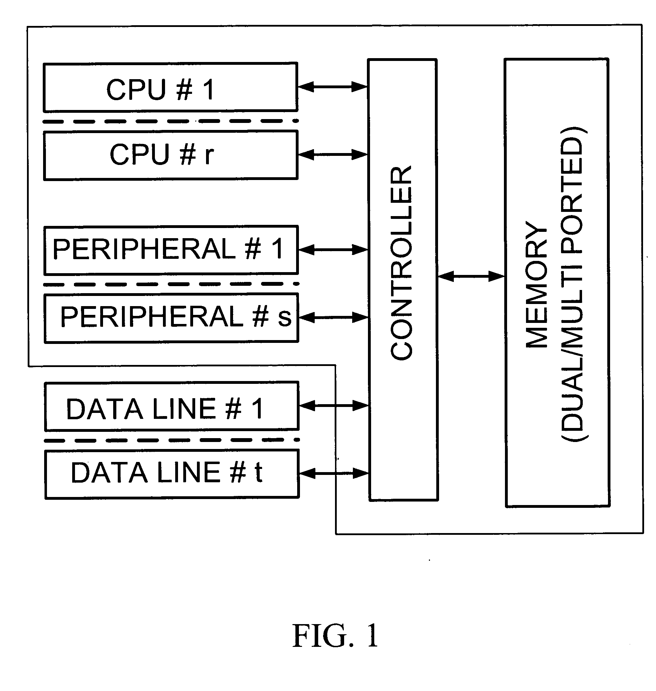

The block diagram depicted in Fig.1, describes the general problem concerning the multiple accesses to a shared memory by a plurality of data streams, such data streams being generated by devices belonging to the system (CPU and peripheral units) or coming to the system from external sources. Data streams can be of the type serial data as well as parallel data, each data stream having its own clock; the memory is of the type allowing two or more devices to have simultaneous read and write independent access; in general such memory are identified as dual-port random access memory (dual-port RAM).

That general problem has a solution in case the memory is shared between data streams generated by two independent devices: those data streams are managed by a controller, or a control logic, which arbitrates the write and read operation to and from the memory.

Using such solution, a dual-port RAM can support fast data exchange in multiprocessor systems as described in the application note: "Dual-port RAMs simplify processor communications" published by Butterworth &Co. on December 10, 1998 (Vol. 12 N° 10).

Increasing the number of the incoming data streams generated by independent devices, the problem can be solved using a single dual-port RAM for each data stream or using a multiport RAM device that is a dual-port RAM combined to form larger dual-port memories. The drawback of those solutions is that they are more expensive and more resources consuming.

The number of RAM blocks available constitutes one of the limits of these solutions and, in general, the problem arises on given families of FPGA (Field-Programmable Gate Arrays) where only a finite number of RAM blocks are available.

A similar situation occur when a discrete components circuit must use a single or a limited number of RAMs to share a large number of data streams.

In the general case, if a large number of data streams must be stored in such memories, saving cost and having a limited number of RAMs available, a sharing method must be implemented.

In the state of the art, several implementation schemes have been proposed.

- The use of a bus controller which provides access to each interface through a controlled waiting mode (see e.g. patent US 2002/0046307 A1)
- The use of an address bus N times larger than the width of a single interface word in order to write N interfaces simultaneously (see e.g. patent US 6292873 B1)
- A pre-synchronization of the incoming data streams (see e.g. article "Shadow Write and Read for AT-Speed BIST of TDM SDRAMs" by Yuejian Wu and Liviu Calin, ICT International Test Conference , 2001 IEEE).

There are many disadvantages in such implementations, concerning a non-optimal resources usage, a cost impact due to the use of control logic or external controllers or a timing overcostrained architecture which is limited by the technological state of the art.

Moreover, if a bus controller is used, a method based on a priority serving algorithm will be usually implemented in order to provide access to each dual port RAM interface. The main disadvantage of such priority serving algorithm is the introduction of waiting states for the different incoming data streams.

## Objects of the Invention

The main object of the present invention is to overcome the drawbacks of the known art by introducing a drastic reduction in the memory resources needed for the storage of the data contained in several data streams.

When this operation is done with discrete components, this leads to save several dual-port RAM devices with a consequent huge cost reduction.

When the function must be integrated on a chip, a cheaper device (equipped with a little number of RAM blocks) can be chosen instead of a more complex and more expensive one, and without the need to adopt controller, or a control logic scheme, which would require a large amount of general purposed circuitry

## Summary of invention

The invention solve that problem by means the device for sharing the access, both in writing and in reading mode, to a single dual-port RAM among many data sources, and the method implementing a time-multiplexed access scheme to the writing and reading interfaces of the dual port RAM.

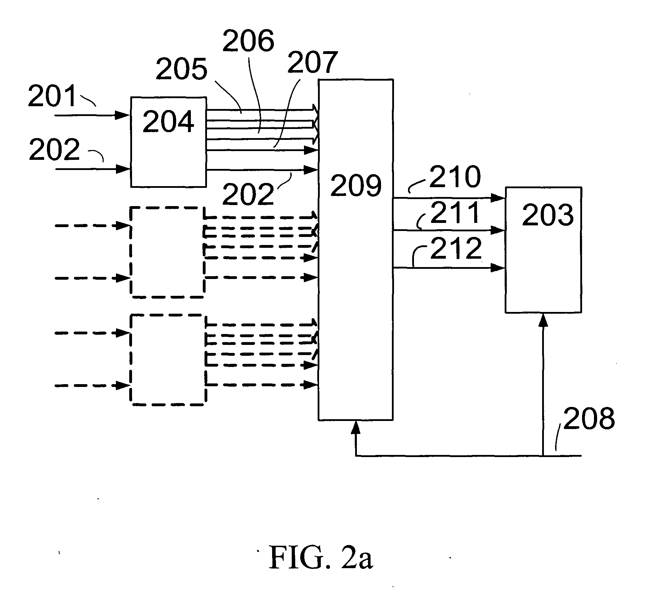

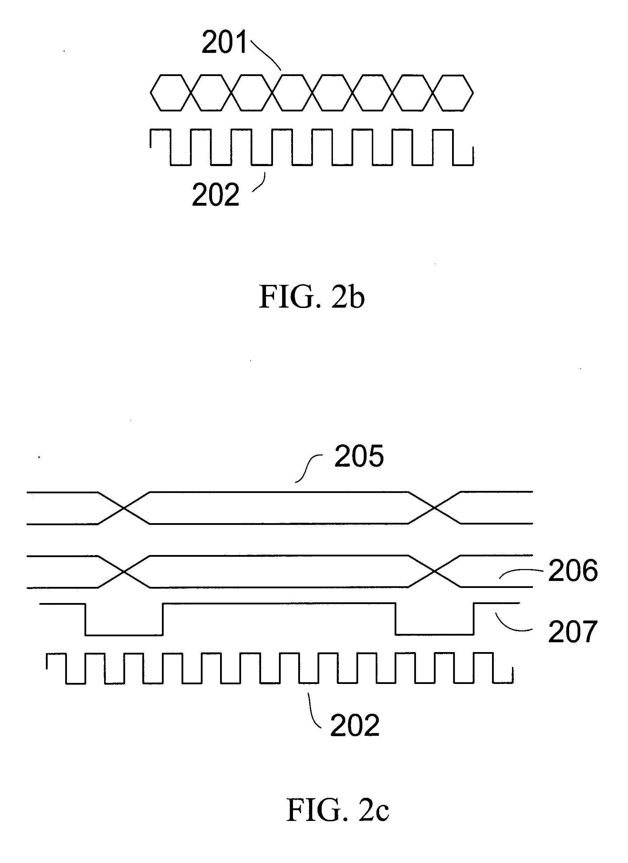

According with a first aspect of the invention and referring to Fig.2a Fig.2b and Fig.2c, N independent data stream (201) of the type serial data as well as parallel data, each coming with an independent clock (202), are processed by N word framers and address generators (204). The word framer and address generators (204) deserialize the data streams to a given word dimension and then generate a correct writing address to the dual-port RAM. Each word framer and address generator outputs parallel data bus (205), address (206) and enable signal (207). Then a RAM access multiplexer (209) performs the time multiplexing of incoming data, addresses and enables to the writing interface of the dual-port RAM (203).

In the similar way M word framers and address generators will produce M data stream from the reading interface of the dual-port RAM.

According with a second aspect of the invention the period (t_ram) of the RAM write clock (208), the minimum length duration (en_min) of the enable (207) and the number of interfaces (N) are tied by the following relation:

$$en\_min >= (N+1) * t\_ram$$

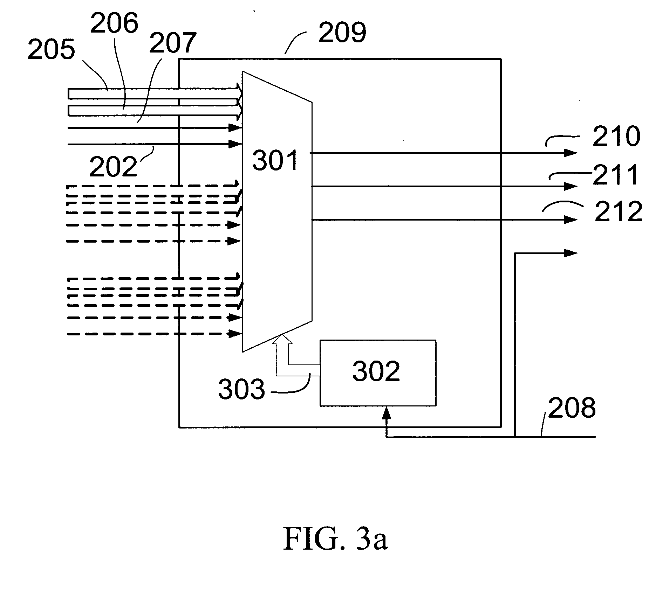

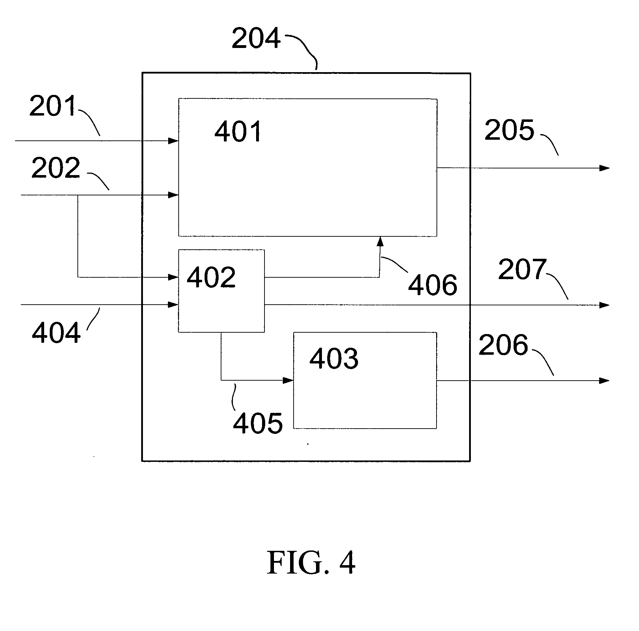

According with a third aspect of the invention and referring to the Fig.3a, the RAM access multiplexer (209) can be of the type having an N-counter (302), clocked by RAM write clock (208), that generates the control signals (303), that multiply to the output of the multiplexer the data (210), address (211) and enable (212) of all the N interfaces According with a fourth aspect of the invention and referring to the Fig. 4, the word framer and address generators (204) can be of the type composed by: word framer (401), counter (402) and memory (403) means.

According with a fifth aspect of the invention the word framer and address generators (204) receive, as input of the counter a synchronization signal (404) that allows the word boundary detection if that feature is required.

Additional features of the present invention which are considered to be novel will set forth in the appended claims taken in conjunction with the accompany drawings.

## Brief description of the drawings.

Further advantages, characteristics and conditions of use will be apparent from the more particular description of exemplary embodiment, which is shown as an example but and without introducing any limitation, as illustrated in appended drawings, were:

Figure 1 is the block diagram of the general problem solved by the invention;
Figure 2a is the block diagram of the memory writing side in accordance with the invention;
Figure 2b describes the incoming data stream and clock;
Figure 2c describes the data stream and clock generated by the word framer and address generators;
Figure 3a is the block diagram of the RAM access multiplexer;
Figure 3b describes the data stream and clock generated by the RAM access multiplexer;

Figure 4 is the block diagram of the word framer and address generators;
Figure 5 is the block diagram of the memory reading side in accordance with the invention;

## Detailed description of a preferred embodiment of the invention

The preferred embodiment of the invention illustrated in the figures and hereinafter described, refers to a device and a method which implements the sharing of a single dual port RAM, formatted in 8-bit-wide locations, among N different incoming data streams (201), of the type serial data, each coming with an independent source clock (202).

According to the same embodiment, the read port of the RAM is shared among M different outgoing data streams (501), each coming with an independent source clock (502).

The bit rates of the data streams and the frequencies of the clocks can be in general different from each other.

The incoming data streams (201) are processed by N word framers and address generators (204) that perform three different operations:

— Deserialize the incoming data streams to the parallel data bus (205) having a predefined width w;
— Generate the writing address (206) to the dual-port RAM;
— Generate the enable signal (207).

The addresses can be generated independently by the N blocks, and in this case N different portions of the dual-block RAM are reserved one for each incoming data stream, or can be generated by an algorithm that shares the locations in RAM among the incoming data stream.

The parallel data bus (205) toggle every w serial clock pulses, where w is the width of the parallel data themselves.

The address follows the same behavior.

The enable is asserted for all the length of the data and address toggle period except the first and last serial clock pulse.

This formatting ensures that data and address are stable before and after the assertion of the enable, so when the enable is high they are surely at a correct electric level. Neither hold/setup violations nor metastability problems arise in this way when the clock passage to the RAM write clock (208) is performed.

According with a preferred embodiment of the invention and referring to the Fig.4, each word framer and address generator (204) is composed by:

- Word framer means (401), receiving the data stream (201) and the serial clock- (202), generated by devices belonging to the system or coming to the system from external sources, and a word latch signal (406) generated from the counter means (402) and producing the parallel data output signal (205);

- Counter means (402), receiving the serial clock (202) and a synchronization signal (404) and producing a word latch signal (406), a word number signal (405) ad the enable (207).

- Memory means (403), receiving the word number signal (405) ad producing the address (206) signal.

The synchronization signal (404) allows the word boundary detection if that feature is required.

A RAM access multiplexer (209) performs a time multiplexing of incoming data, addresses and enables to the writing interface of the dual-port RAM

In Fig.3a the behavior of the RAM access multiplexer (209), relevant to the preferred embodiment of the invention, is shown.

An N-counter (302), clocked by RAM write clock (208) generates control signals (303) that multiply to the output of the multiplexer (301) the data (210) , address (211) and enable (212) of all the N interfaces.

At each clock pulse a single interface is brought to the output. At the following clock pulse the following interface is processed in the same way, and so on.

The period (t_ram) of the RAM write clock (208), the minimum length duration (en_min) of the enable (207) and the number of interfaces (N) are tied by the following relation:

$$en\_min >= (N+1) * t\_ram$$

which ensures that in a complete cycle of the N-counter a stable data/address set marked by a high enable value is surely multiplexed to the RAM. It can happen then a single set of valid data and address is multiplexed more than once to the RAM writing interface, repeating the writing operation to the same location without affecting the correct data storage.

The multiplexed data (210), multiplexed address (211) and multiplexed enable (212) are sent to the RAM writing port along with the RAM clock.

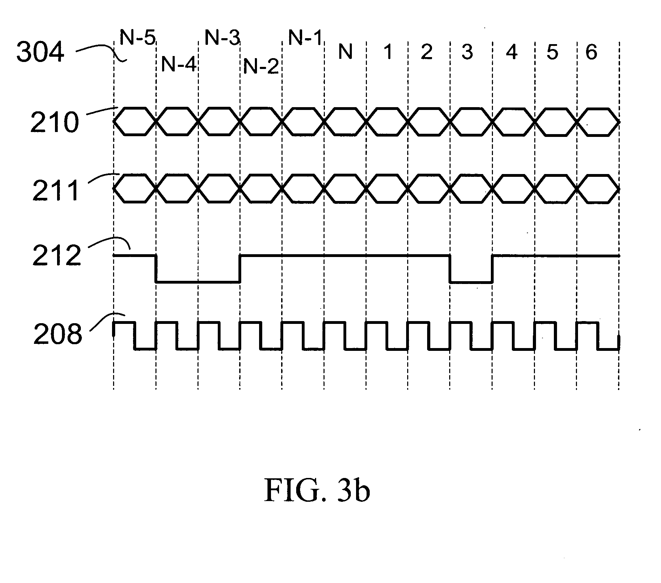

In Fig. 3b the output of the RAM access multiplexer is shown in detail.

At each RAM write clock (208) pulse, the N-counter enables a different time slot number (304). In each time slot the multiplexed data (210), multiplexed address (211) and multiplexed enable (212) of the Nth incoming data stream is multiplexed to the RAM writing interface. If the enable is high, the writing operation is effectively performed, else data and address are not yet stable so the writing operation is not performed.

The method for sharing the access to a single dual-port RAM in reading mode descends from the writing method with the following differences.

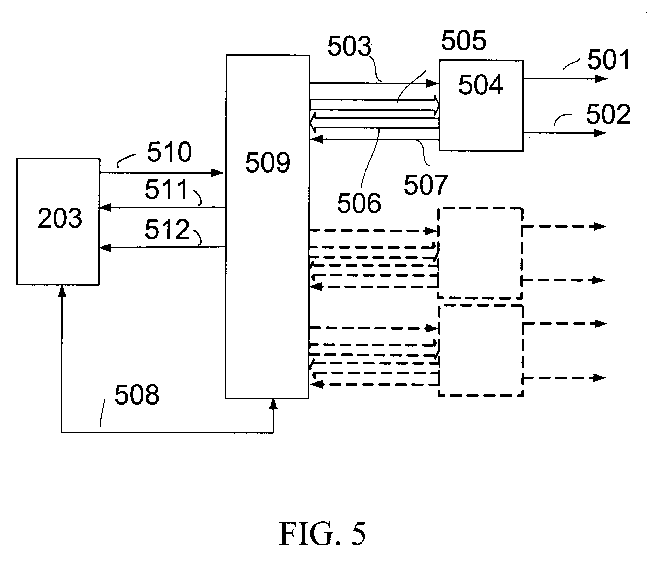

According with a preferred embodiment of the invention and referring to the Fig.5, the "word deserializers and address generators" (504) generates addresses (506) and enables (507) which are multiplexed by a mux/demux (509) to the reading port of the RAM (203) on the multiplexed address (511) and multiplexed enables (512) lines through the RAM read clock (508) which can be in general different from the RAM write clock (208). The RAM outputs the multiplexed data (510) which are passed to the mux/demux (509). The mux/demux (509) demultiplexes such data to the word deserializers and address generators (504) on the demultiplexed data lines (505). M different enable lines (503) are provided to the M word deserializers and address generators (504) in order to indicate which data belong to each single word deserializer and address generator (504).

The word deserializers and address generators (504) perform the deserialization of the data streams to the serial output lines (501) each coming with a different clock source (502).

Though the invention has further been described with reference to specific devices implementing the word framer and address generators and the RAM access multiplexer, it is clear that the invention can be applied in the future to any device implementing the time-multiplexed access scheme object of the invention but using word framer and address generators circuits and RAM access multiplexer circuits known to the technicians expert in that field.

**Claims**

1. Method for N independent data stream accessing the interface of a single RAM according to the time-multiplexed access technique **characterized by** the execution in sequence of the following steps:

   - receiving N said independent data streams, each one having independent clock, at the input of N word framers and address generators (204);
   - generating by means of each N word framers and address generators (204), for each one of the N independents serial data streams,

     o parallel data signals and outputting the generated signals on a parallel data bus (205),
     o the writing address (206) of said parallel data signals
     o the enable signal (207), each enable signal having a length enable duration depending on the independent clock of the independent serial data stream;

   - multiplexing said parallel data signal (205) in the time domain, generating the multiplexed data stream, the multiplexed addresses and the multiplexed enable by means of a RAM access multiplexer (209) having an appropriate clock period (t_ram);

- writing the multiplexed data signals to the interface of a dual-ported memory according with the multiplexed addresses and the multiplexed enable.

2. The method of claim 1 **characterized in that** the period (t_ram) of the RAM write clock (208), the minimum length duration (en_min) of the enable (207) and the number of interfaces (N) are tied by the following relation:

$$en\_min >= (N+1) * t\_ram$$

3. The method of claim 1 **characterized in that** the address generate by means of N word framers and address generators (204) are according to an algorithm that shares the locations in the memory means.

4. The method of claim 1, 2 and 3 **characterized in that** the incoming data stream is of the type serial data stream

5. The method of claim 1, 2 and 3 **characterized in that** the incoming data stream is of the type parallel data stream.

6. Device for sharing the access to a single dual-port RAM among N data sources **characterized in that** it comprises:

- At least N receiving means of the type word framer and address generator (204), adapted to:

   o deserializing the data streams and outputting the received signals on a parallel data bus (205) having a predefined width w,

   o generating the writing address (206) to the dual-port RAM

   o generating an enable signal;

- A RAM access multiplexer (209), adapted to receive said parallel data signals, said writing addresses and said enable signals from the word framer and address generator (204) means and adapted to perform a time multiplexing of such incoming data, to the writing interface of the dual-port RAM.

7. The device of claim 6 **characterized in that** the word framer and address generator (204) comprises:

- Word framer means (401), receiving the data stream (201) and the serial clock (202), generated by devices belonging to the system or coming to the system from external sources, and a word latch signal (406) generated from the counter means (402) and producing the parallel data output signal (205)

- Counter means (402), receiving the serial clock (202) and a synchronization signal (404) and producing a word latch signal (406), a word number signal (405) ad the enable (207)

- Memory means (403), receiving the word number signal (405) ad producing the address (206) signal.

8. The device of claim 6 **characterized in that** the RAM access multiplexer (209) comprises:

- N-counter (302), clocked by RAM write clock (208), generating the control signals (303) towards the multiplexer (301);

- multiplexer (301) receiving data (210) , address (211) and enable (212) from all the N interfaces and generating, according with the control signal (303) coming from the N-counter, the multiplexed data (210) , multiplexed address (211) and multiplexed enable (212) to the writing interface of the dual-port RAM (203).

FIG. 1

FIG. 2a

FIG. 2b

FIG. 2c

FIG. 3a

FIG. 3b

FIG. 4

FIG. 5

# EP 1 550 953 A1

**European Patent Office**

## EUROPEAN SEARCH REPORT

**Application Number**

EP 03 42 5829

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 598 575 A (DENT PAUL W ET AL) 28 January 1997 (1997-01-28) * column 6, lines 18-30 * * column 12, line 52 - column 14, line 66; figures 1-4 * | 1-8 | G06F13/16 G11C7/10 |
| Y | US 6 567 426 B1 (EZER GULBIN ET AL) 20 May 2003 (2003-05-20) * column 5, line 61 - column 10, line 59 * | 1-7 | |
| Y | US 5 809 538 A (YILMAZ SERDAR ET AL) 15 September 1998 (1998-09-15) * column 5, lines 23-38 * * column 11, lines 13-29 * | 1-7 | |
| A | US 5 625 796 A (BUCHHOLZ DALE R ET AL) 29 April 1997 (1997-04-29) * figure 3 * | 1,6,7 | |
| A | US 5 659 688 A (NIMISHAKAVI HANUMANTHRAO ET AL) 19 August 1997 (1997-08-19) * abstract * | | TECHNICAL FIELDS SEARCHED (Int.Cl.7) G06F G11C |

The present search report has been drawn up for all claims

| Place of search | Date of completion of the search | Examiner |
|---|---|---|
| The Hague | 5 July 2004 | Czarik, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                     EP 03 42 5829

This annex lists the patent family members relating to the patent documents cited in  the above-mentioned European search report.
The members are as contained in the European Patent Office EDP file on
The European Patent Office is in no way liable for these particulars which are merely  given for the purpose of information.

05-07-2004

| Patent document cited in search report | | Publication date | Patent family member(s) | | Publication date |
|---|---|---|---|---|---|
| US 5598575 | A | 28-01-1997 | AU | 675169 B2 | 23-01-1997 |
| | | | AU | 7741494 A | 18-05-1995 |
| | | | CN | 1117318 A ,B | 21-02-1996 |
| | | | DE | 4438975 A1 | 29-06-1995 |
| | | | FI | 953204 A | 28-08-1995 |
| | | | FR | 2714747 A1 | 07-07-1995 |
| | | | GB | 2283596 A ,B | 10-05-1995 |
| | | | JP | 7281946 A | 27-10-1995 |
| | | | WO | 9512854 A1 | 11-05-1995 |
| US 6567426 | B1 | 20-05-2003 | AT | 256311 T | 15-12-2003 |
| | | | DE | 69913500 D1 | 22-01-2004 |
| | | | EP | 1058891 A1 | 13-12-2000 |
| | | | JP | 2002506251 T | 26-02-2002 |
| | | | WO | 9945472 A1 | 10-09-1999 |
| US 5809538 | A | 15-09-1998 | NONE | | |
| US 5625796 | A | 29-04-1997 | EP | 0421696 A2 | 10-04-1991 |
| | | | JP | 3131945 A | 05-06-1991 |
| US 5659688 | A | 19-08-1997 | US | 5471588 A | 28-11-1995 |

For more details about this annex : see Official Journal of the European Patent Office, No. 12/82